Europäisches Patentamt

European Patent Office

Office européen des brevets

(19)

(11) **EP 0 724 024 B1**

(12) **EUROPÄISCHE PATENTSCHRIFT**

(45) Veröffentlichungstag und Bekanntmachung des Hinweises auf die Patenterteilung:
**12.05.1999 Patentblatt 1999/19**

(51) Int Cl.$^6$: **C23C 14/10**, C23C 16/40, G02B 5/30, G02B 1/10, C08J 7/06

(21) Anmeldenummer: **96100598.0**

(22) Anmeldetag: **17.01.1996**

(54) **Thermostabile Polarisatoren**

Thermally stable polarizers

Polariseurs thermostables

(84) Benannte Vertragsstaaten:
**BE CH DE FR GB IT LI NL SE**

(30) Priorität: **30.01.1995 DE 19502806**

(43) Veröffentlichungstag der Anmeldung:
**31.07.1996 Patentblatt 1996/31**

(73) Patentinhaber: **BAYER AG**
**51368 Leverkusen (DE)**

(72) Erfinder:
- **Ostoja Starzewski, Karl-Heinz A., Dr.**
  **D-61118 Bad Vilbel (DE)**
- **Thurm, Siegfried, Dr.**
  **D-40668 Meerbusch (DE)**

(56) Entgegenhaltungen:
**US-A- 4 818 624        US-A- 5 049 427**

- **DATABASE WPI Section Ch, Week 8628 Derwent Publications Ltd., London, GB; Class A85, AN 86-180933 XP002003377 & JP-A-61 116 332 (SUMITOMO BAKELITE KK) , 3. Juni 1986**
- **DATABASE WPI Section Ch, Week 9427 Derwent Publications Ltd., London, GB; Class A89, AN 94-223024 XP002003378 & JP-A-06 160 630 (FUJIMORI IND CO LTD) , 7. Juni 1994**
- **DATABASE WPI Section Ch, Week 9501 Derwent Publications Ltd., London, GB; Class L03, AN 95-001799 XP002003379 & JP-A-06 289 227 (OIKE KOGYO KK) , 18. Oktober 1994**

**Beschreibung**

Die Erfindung betrifft thermostabile, biegsame Polarisatoren, die eine polarisierende Schicht aus einem Polymer mit konjugierten Doppelbindungen und mit einer $SiO_x$-versiegelten Oberfläche enthalten. Ein weiterer Gegenstand der Erfindung sind solche Polarisatoren, die zusätzlich mit Deckschichten verklebt sind.

In US 4 818 624 wird die Stabilisierung von Licht-Polarisatoren durch Oberflächen-Silylierung mit einem Organosilan beschrieben. Die Wirkung ist unzureichend, da schon bei 49 bis 74°C (120 bis 165°F) nach 24 h Ausbleichung und Farbverschiebung beobachtet werden.

Die Herstellung von Laminaten aus verschiedenen Substraten mit dazwischen befindlichen Adhäsions-(kleb-) Schichten ist bekannt. In US 5 049 427 werden laminierte Polarisatoren, die eine polarisierende Kernschicht aus einem Polyacerylen(PAC)-haltigen Polymer (POLPAC) und transparente Deckschichten aufweisen, wobei die Schichten mittels eines speziellen Polyurethanpolyharnstoffs verklebt werden, beschrieben.

Obwohl POLPAC-Polarisatoren bereits ausgezeichnete Eigenschaften aufweisen, ist die Stabilität bei extremen Bedingungen noch nicht ausreichend. Nach Lagerung bei 90°C während 500 Stunden hat der Polarisator sich in seiner Transmission gegenüber unpolarisiertem Licht verändert, wobei die Transmissionsänderung $\Delta T_{unpol}$ mehr als 5 % beträgt.

Ein Einsatz in optischen Displays, die besonders stark der Einwirkung von Wärme ausgesetzt sind (z.B. Armaturenbretter in Automobilen), ist aber erst möglich, wenn unter diesen Bedingungen der Rückgang der optischen Eigenschaften $\Delta T_{unpol}$ und $\Delta P$ des Polarisators höchstens 5 % beträgt, wobei $\Delta P$ die Änderung des Polarisationsgrades ist. Konstante optische Eigenschaften von z.B. POLPAC-Polarisatoren wurden bei 100°C während 1000 Stunden nach Verklebung zwischen Glasplatten beschrieben. Solche Verbundsysteme sind jedoch für die Display-Herstellung weniger geeignet. Vielmehr sind biegsame Polarisatoren gewünscht und zwar sowohl hinsichtlich der Verarbeitungseigenschaften, als auch im Hinblick auf flexible Kunststoff-Displays.

Aufgabe der Erfindung war daher, Polarisatoren auf Basis eines Polymers mit konjugierten Doppelbindungen herzustellen, die die vorstehend genannten Bedingungen erfüllen.

Es wurde nun überraschend gefunden, daß diese Aufgabe gelöst werden kann, wenn der Polarisator an seiner Oberfläche mit einer $SiO_x$-Schicht versiegelt wird.

Die Versiegelung gemäß Erfindung erfolgt durch Physical Vapor Deposition (PVD), durch Plasma-Chemical Vapor Deposition (Plasma-CVD) oder durch Sputtering. Diese Verfahren und ihre Ausführungsvarianten sind dem Fachmann bekannt. In bevorzugter Weise wird das Verfahren der PVD angewandt.

Bei der Versiegelung durch PVD wird marktgängiges SiO in Abwesenheit oder Anwesenheit verschiedener $O_2$-Mengen verdampft und auf dem zu versiegelnden Polarisator niedergeschlagen. Bei Abwesenheit von $O_2$ erhält man eine SiO-Schutzschicht, Schutzschicht, bei Anwesenheit von $O_2$ steigt der Sauerstoffgehalt der bis schließlich bei überschüssigem $O_2$ eine Schicht von $SiO_2$ abgeschieden wird. $SiO_x$ mit beliebigen Werten von 1 bis 2 für x bezeichnet diesen Bereich. Für die Zwecke der Stabilisierung des Polarisators gegenüber Sauerstoff sind Werte von 1,1 bis 1,9, besonders von 1,4 bis 1,8 bevorzugt. Jedoch sind Werte bis zu x = 2 zur Erreichung mechanischer Eigenschaften (z.B. Kratzfestigkeit) wertvoll.

In analoger Weise kann die Versiegelung mit Hilfe der Plasma-CVD erreicht werden, wobei man $SiO_x$-Schutzschichten durch eine chemische Reaktion, beispielsweise eines Silans mit einer $O_2$-Quelle, wie $N_2O$ oder anderen Stickstoffoxiden, und Niederschlagung auf dem zu versiegelnden Polarisator erhält.

In einer Variante kann in zeitlicher Aufeinanderfolge die Schutzschicht zunächst aus sauerstoffärmerem $SiO_x$ mit x = 1,1 bis 1,8 und dann aus sauerstoffreicherem $SiO_x$ mit x = 1,4 bis 2 aufgebaut werden.

Die $SiO_x$-Schutzschicht hat eine Dicke von 10 nm bis 10 μm, bevorzugt von 100 nm bis 1 μm. Zur weiteren Stabilisierung können auch Schnittkanten in der dargestellten Weise versiegelt werden.

Ein weiterer Gegenstand der Erfindung ist ein laminierter, biegsamer Polarisator aus einer polarisierenden Kernschicht aus einem Polymer mit konjugierten Doppelbindungen und beidseitig aufgebrachten transparenten, biegsamen Deckschichten, dadurch gekennzeichnet, daß die mit einer $SiO_x$-Schutzschicht versiegelte Kernschicht und Deckschichten mit einer Silikatschicht oder mit einem organischen Kleber verklebt sind und der so laminierte Polarisator biegsam ist. Der Polarisator kann mittels der Silikatschicht auch zum Verbund mit Glasplatten, optischen Linsen oder Prismen verwendet werden. Wird der Polarisator mit Hilfe einer Silikatschicht oder durch einen organischen Kleber einseitig auf ein Glasdisplay oder einen anderen Glaskörper aufgeklebt, so genügt es, seine freie Oberfläche durch eine $SiO_x$-Schicht zu schützen.

Solche Silikatschichten werden auf die mit einer $SiO_x$-Schutzschicht versiegelte Kernschicht und/oder die Deckschichten vorzugsweise in Form einer wäßrigen Lösung aufgebracht. Geeignete wäßrige Lösungen von Silikaten sind die bekannten wässrigen Lösungen von Natron- und Kaliwasserglas. Übliche Wasserglassorten haben im Falle von Natronwasserglas Feststoffgehalte von 25 bis 60 Gew.-% und $SiO_2$-Gehalte von 20 bis 40 Gew.-%; der Rest des Feststoffgehaltes ist $Na_2O$; und im Falle von Kaliwasserglas Feststoffgehalte von 25 bis 40 Gew.-% und $SiO_2$-Gehalte von 20 bis 30 Gew.-%; der Rest des Feststoffgehaltes ist $K_2O$. Um dünnere Silikatschichten zu erhalten, können diese Lösungen noch mit Wasser verdünnt werden. Bevorzugt sind möglichst hohe $SiO_2$-Anteile, das sind solche, bei denen das Gewichtsverhältnis $SiO_2/Na_2O \geq 3$ bzw. $SiO_2/K_2O \geq 2,2$ ist. Durch die Verwendung der Silikatschichten erübrigen sich organische Klebstoffe, wie sie in großer Zahl in US 5 049 427 beschrieben sind.

Die Silikatschichten stabilisieren die Eigenschaften des Polarisators zusätzlich zur $SiO_x$-Schicht bereits in einer Schichtdicke von $\leq 2\,\mu m$. Vorzugsweise werden 100 mg bis 2 g Wasserglas (Feststoff)/$m^2$ zu verklebende Fläche benötigt, um eine thermostabile Verklebung des Laminates zu erreichen.

In einer bevorzugten Ausführungsform werden die $SiO_x$-versiegelte Kernschicht und/oder Deckschicht vor der Beschichtung mit der Silikatlösung einer Behandlung mit einem Silan oder mit einem Borat unterworfen. Diese Maßnahme verbessert insbesondere die Verbundfestigkeit.

Geeignete Silane entsprechen der Formel:

$$Si\,(R_1)_n\,(R_2)_{4-n}$$

worin

R$_1$　unabhängig voneinander Halogen oder Alkoxy,
R$_2$　unabhängig voneinander Alkyl oder Alkenyl und
n　eine Zahl 2, 3 oder 4 bedeuten.

Alkyl- und Alkoxyreste $R_1$ und $R_2$ können substituiert sein.

Geeignete Silane sind z.B. Tetramethoxysilan, Tetraethoxysilan, Methyltrimethoxysilan, Dimethyldimethoxysilan, Ethyltriethoxysilan, Dimethyldichlorsilan, Vinylmethyldichlorsilan, Vinyltriethoxysilan. Die Silane können auch in die Silikatlösung direkt eingemischt, z.B. einemulgiert werden.

Geeignete Borate sind z.B. Borsäure und Borax. Borsäure und Borate können auch direkt in die Wasserglaslösung eingemischt bzw. darin gelöst werden.

Die Silane und Borate werden insbesondere so aufgebracht, daß die $SiO_x$-versiegelte Kernschicht und/oder die Deckschicht in eine Lösung der Verbindung oder, falls die Verbindung flüssig ist, in die reine Verbindung getaucht und wieder heraus genommen wird. Die dabei aufgenommene Menge ist so gering, daß sie durch Wiegen nicht sicher feststellbar ist, aber üblicherweise unter 1 g/$m^2$ beträgt.

Die Deckschichten haben z.B. Dicken von 5 μm bis 1 mm, bevorzugt 20 bis 200 μm. Die polarisierende Kernschicht hat z.B. eine Dicke von 1 bis 200 μm, bevorzugt 5 bis 50 μm.

Als Deckschichten kommen beispielsweise aromatische Polyester, Polyacrylnitrile, Poly(meth)acrylate, Polysulfone, aromatische Polycarbonate, Celluloseacetate, Celluloseacetobutyrate, Polyamide, Polyhydantoine, Polyimide, Polyamidimide, Polyparaphenylenbenzo-bis-imidazole und -oxazole und Polyetherketone in Frage, wobei Polyester, Poly(meth)acrylate, Polycarbonate und Celluloseester bevorzugt sind. Die Transparenz dieser Materialien ist ihr wichtigstes Merkmal. Sie werden im allgemeinen als Folien eingesetzt.

Die polarisierende Kernschicht für den erfindungsgemäß an den Oberflächen mit $SiO_x$ versiegelten Polarisator ist ein Polymer mit konjugierten Doppelbindungen. Solche Polymere sind bekannt. So beschreibt beispielsweise US 3 914 017 die teilweise Dehydration von Polyvinylalkohol, wobei Bereiche konjugierter Doppelbindungen in der Polymerhauptkette entstehen. Diese Bereiche konjugierter Doppelbindungen sind im allgemeinen recht kurz (Durchschnittswert 2 bis 15 C=C). Die Dehydratation kann rein thermisch oder durch Säurekatalyse vorgenommen werden. Der zu dehydratisierende Polyvinylakohol kann weiterhin mit anderen Vinylmonomeren, wie (Meth)Acrylaten, Acrylnitril, Styrol, Vinylacetat oder Vinylchlorid, gepfropft sein. In analoger Weise können konjugierte Doppelbindungen in Polymeren durch HCl-Abspaltung aus Polyvinylchlorid oder durch Essigsäure-Abspaltung aus Polyvinylacetat erzeugt werden. Schließlich kann durch Polymerisation von Acetylen in einem anderen, in Lösung befindlichen Polymer das oben erwähnte PAC-haltige Polymer gebildet werden. Alle diese Polymere sind erfindungsgemäß einsetzbar.

Die polarisierende Kernschicht ist in bevorzugter Weise in teilweise dehydratisierter Polyvinylalkohol oder ein PAC-haltiges Polymer.

Die polarisierende Kernschicht ist in besonders bevorzugter Weise ein Polarisator aus PAC-haltigen Polymerprodukten, deren Matrix ein Polymer mit polaren Gruppen ist, und die einen maximalen Polarisationsgrad P von mindestens 90 %, bevorzugt mindestens 95 %, besonders bevorzugt mindestens 98 %, und ein maximales dichroitisches Verhältnis $Q_E$ von 5 oder größer, vorzugsweise 10 oder größer haben, beides bezogen auf den Bereich des sichtbaren Lichts. Diese Polarisatoren werden als Folien eingesetzt, an denen durch Verstrecken eine Vorzugsrichtung erzeugt wurde. Der Verstreckungsgrad ε beträgt mehr als 200 %, bevorzugt mindestens 400 %, besonders bevorzugt 500 % bis 1 000 %.

Besonders bevorzugte polarisierende Kernschichten bestehen aus PAC-haltigen Polymerprodukten, deren Matrix ein teilweise dehydratisierter Polyvinylalkohol ist und deren polarisierende Wirkung sich vom nicht sichtbaren nahen ultravioletten Wellenlängenbereich (< 450 nm) über den sichtbaren Wellenlängenbereich (450 bis 700 nm) bis in den nahen infraroten Wellenlängenbereich (700 bis 850 nm) erstreckt. Solche teilweise dehydratisierten POLPAC-Polarisatoren können hergestellt werden, indem man

a) den verwendeten Polyvinylalkohol vor der Acetylenpolymerisation bei 150 bis 250°C tempert, bis die gewünschte Dehydratisierung, erkennbar an der Verfärbung, erreicht ist, dann Acetylen in der Lösung dieses Polyvinylalkohols polymerisiert, daraus einen Film erzeugt und diesen reckt; oder

b) indem man einen POLPAC-Film reckt und anschließend tempert, wobei die Temperung an der Luft oder zur Erhaltung der langwelligen Polarisationswirkung unter Luftausschluß erfolgt.

Die Folie kann auch, um den Dehydratisierungsprozeß zu beschleunigen, vor oder nach dem Recken mit einer Säure, wie beispielsweise mit HCl-Gas, vorbehandelt werden. Man kann auch geringe Mengen an Säuren, wie beispielsweise Salzsäure, Phosphorsäure, Sulfonsäure oder Sulfonsäure-haltige Substanzen dem Polymer vor der Folienherstellung zusetzen.

Der Polarisationsgrad P für linear polarisiertes Licht und der Verstreckungsgrad $\varepsilon$ sind wie folgt definiert:

$$P = \frac{\text{Transmission in Durchlaßstellung minus Transmission in Sperrstellung}}{\text{Transmission in Durchlaßstellung plus Transmission in Sperrstellung}} \times 100$$

$$\varepsilon = \frac{l-l_o}{l_o} \cdot 100$$

(l = Länge nach dem Verstrecken; $l_o$ = Länge vor dem Verstrecken)

Die Herstellung PAC-haltiger Polymerprodukte ist z.B. aus US 4 893 911, US 5 049 427, US 5 051 286 oder US 5 073 014 bekannt. Dabei wird Acetylen in Gegenwart eines geeigneten Katalysators, beispielsweise in Gegenwart von Nickel(O)-Komplexen, in einer Lösung eines anderen Polymer polymerisiert.

Das von PAC verschiedene Polymer liegt dabei in einer Menge von 1 bis 99,9 Gew.-%, bevorzugt 50 bis 99,9 Gew.-%, bezogen auf den gesamten Polarisator, vor.

Beispiele für geeignete andere Polymere sind Polyvinylchlorid, Polyvinylbutyral, Polyvinylalkohol (PVA), teilverseiftes Polyvinylacetat (PVAC) und andere Vinylalkohol enthaltende (Co)-Polymere, Polyacrylnitril, Acrylnitril enthaltende Copolymere, Polyvinylpyrrolidon, Methylcellulose und andere Cellulose-Derivate sowie Polycarbonat. Bevorzugt werden Lösungen von PVA und teilverseiftem PVAC eingesetzt.

Lösungsmittel für die anderen Polymere sind beispielsweise N-Methylpyrrolidon (NMP), Dimethylformamid (DMF), Dimethylsulfoxid (DMSO) u.a. Die Konzentration des Polymer im Lösungsmittel beträgt 1 bis 20 Gew.-%, bevorzugt 2 bis 10 Gew.-%.

Die erfindungsgemäßen laminierten Polarisatoren zeichnen sich durch eine Reihe hervorragender Eigenschaften aus:

1. eine hohe Lichtdurchlässigkeit,
2. ein hohes Maß an Lichtechtheit
3. Thermostabilität der polarisierenden Kernschicht
4. ausgezeichnete mechanische Eigenschaften.

Die erfindungsgemäßen Polarisatoren eignen sich für alle Einsatzgebiete, in denen Polarisationsfolien Verwendung finden, insbesondere in der Optik (z.B. Polarisationsmikroskope, Fotographie, Antireflexausrüstung bei Sonnen- und Skibrillen) und für Flüssigkristall-Anzeigen (LC-Displays), z.B. in Uhren, Taschenrechnern, Laptops, Computern, Anzeigen, Projektionsdisplays, Videospielen, Camcordern und Flachbildfernsehern.

Bei 80°C besitzen selbst unkaschierte POLPAC-Folien ohne Stabilisatoren gute Stabilität, wobei die Veränderungen in der Transmission ($\Delta$T) nach 500 Stunden bei 80°C an Luft 2-3 % und im Polarisationsgrad ($\Delta$P) unter 1 % beträgt.

Der erfindungsgemäße Polarisator kann neben den konjugierten Doppelbindungen, beispielsweise neben dem Polyacetylen, zusätzliche, dichroitische Substanzen, z.B. Iod oder dichroitische Farbstoffe, enthalten. Polyacetylen macht jedoch wenigstens 50 Gew.-%, vorzugsweise wenigstens 80 Gew.-% der Gesamtmenge an dichroitischen Substanzen aus.

**Beispiele**

**Beispiel 1**

Eine um 700 % gereckte POLPAC-Folie mit einer Schichtdicke von 11 μm hatte bei 600 nm (polarisiertes Licht) eine Transmission T von 38,7 % und einen Polarisationsgrad P von 99,99 %. Nach 500 Stunden bei 80°C war die Transmission auf 41,7 % gestiegen und der Polarisationsgrad nur auf 99,89 % gefallen.

**Beispiel 2**

Die gleiche Folie wie in Beispiel 1 wurde bei 90°C gehalten. Hierbei stieg die Transmission bei 600 nm bereits nach 270 Stunden um 5,1 %-Punkte, wobei der Polarisationsgrad um 1,84 %-Punkte fiel.

**Beispiel 3**

Ein Probenstück einer Folie, ähnlich wie in Beispiel 1, jedoch um 600 % gereckt, der Abmessung 60 mm x 60 mm wurde in einer Aufdampfanlage A 1100 der Fa. Leybold-Heraeus, Hanau, BRD, auf einem rotierbaren Substrathalter befestigt. Anschließend wurde die Prozeßkammer der Aufdampfanlage geschlossen und auf ca. $10^{-3}$ Pa evakuiert. Danach wurden $O_2$ bis zu einem Druck von 7 Pa eingelassen und der Drehantrieb des Substrathalters eingeschaltet, so daß dieser mit 20 U/min rotierte. Durch Anlegen einer Spannung von -480 V gegen Erde an eine als Kathode geschaltete Al-Platte wurde ein Niederdruckplasma gezündet. In diesem Plasma wurden die Proben zwei Minuten mit einer Leistung von 5,6 Watt behandelt. Danach wurde die Spannung abgeschaltet, die $O_2$-Zugabe beendet und die Prozeßkammer auf $10^{-4}$ Pa evakuiert.

Nach Erreichen dieses Druckes wurde erneut $O_2$ in die Prozeßkammer eingeleitet, bis sich ein Druck von $10^{-2}$ Pa einstellte. Nach Erreichen dieses Druckes wurde die Elektronenstrahlkanone eingeschaltet und das zu verdampfende SiO (Handelsname Patinal, Fa. Merck, Darmstadt), welches sich in einem wassergekühlten Cu-Tiegel befand, mit einer Leistung von 400 W innerhalb von vier Minuten auf ca. 1950 K erhitzt. Anschließend wurde eine bewegliche Blende zwischen Elektronenstrahlkanone und Substrathalter entfernt und die Folienstücke für 400 sec mit einer Rate von 0,5 nm/sec beschichtet. Danach wurde die Blende wieder zwischen Elektronenstrahlkanone und Substrathalter eingebracht, die $O_2$-Zugabe abgestellt und der Beschichtungsvorgang beendet. Nach dem Abschalten der Elektronenstrahlkanone und der Abkühlung des Verdampfungsgutes wurde die Prozeßkammer belüftet, die einseitig beschichtete Folie entnommen, gewendet und wie vorstehend beschrieben auf der noch unbeschichteten Seite bedampft.

Die beidseitig $SiO_x$-beschichtete Folie (x = 1,7), und zwar 200 nm auf jeder Seite, wurde unkaschiert einem 90°C-Wärmetest unterzogen. Dabei stieg die Transmission in 480 Stunden nur um 2,1 % (von 33,3 % auf 35,4 %). Der Polarisationsgrad nahm nur um 0,5 % ab (von 99,8 % auf 99,3 %), beides gemessen bei 600 nm.

**Beispiel 4**

Das Beispiel 3 wurde mit einer um 600 % gereckten Folie aus dehydratisiertem gepfropften Polyvinylalkohol wiederholt. Das Polymer für diese Folie war durch Pfropfung von Polyvinylalkohol mit Ethylacrylat und Methyl-methacrylat und anschließende $H_2O$-Abspaltung durch Behandlung mit wasserfreiem Chlorwasserstoff erhalten worden. Die $SiO_x$-Beschichtung betrug 180 nm auf jeder Seite. Beim Wärmetest veränderte sich die Transmission um weniger als 2 % und der Polarisationsgrad um weniger als 1 %, beides gemessen bei 600 nm.

**Beispiel 5**

Eine 23 μm dicke Folie aus Polyvinylalkohol (hergestellt durch Verseifung von Polyvinylacetat, Verseifungsgrad: 99 %) wurde bei Raumtemperatur 5 Min. lang einer Atmosphäre aus HCl-Gas ausgesetzt, danach bei 200°C monoaxial auf die 7fache Länge verstreckt und noch weitere 15 Min. lang bei 200°C unter der Streckspannung gehalten. Die Folie hatte danach eine Dicke von 12 μm. Die Messung mit polarisiertem Licht bei 600 nm ergab eine Transmission von 43,9 % und einen Polarisationsgrad von 93,9 %. Die Folie wurde danach mit $SiO_x$ (x = 1,7) in der in Beispiel 3 beschriebenen Weise beschichtet. Eine erneute Messung nach dem Wärmetest bei 90°C ergab eine Veränderung der Transmission um weniger als 2 % und die des Polarisationsgrades um 0,9 %.

**Beispiel 6**

Ein POLPAC Film wurde mit gasförmigem HCl behandelt und unter Argon auf 700 %, d.h. das 8-fache seiner Länge gereckt und anschließend noch 15 Minuten bei 200°C an der Luft getempert. Die Transmission T betrug bei 600 nm 38,5 %, der Polarisationsgrad P 99,99 %. Die Polarisationswirkung war durch die Temperung bei 400 nm von 81 % auf 96 % gestiegen. Die Polarisationswirkung bei 700 nm war von 99,8 % nur auf 98,1 % gefallen. Nach $SiO_x$-Beschichtung waren die Veränderungen im 20-tägigen Wärmetest bei 90°C $\Delta T < 2$ % und $\Delta P < 1$ %. Wurde die Temperung unter Argon durchgeführt, entfiel der Abfall des Polarisationsgrades bei 700 nm.

**Patentansprüche**

1. Thermostabiler, biegsamer Polarisator mit einer polarisierenden Schicht aus einem Polymer mit konjugierten Doppelbindungen, dadurch gekennzeichnet, daß er mit $SiO_x$ versiegelte Oberflächen aufweist, worin x beliebige Werte von 1 bis 2, bevorzugt von 1,1 bis 1,9, besonders bevorzugt von 1,4 bis 1,8 annimmt.

2. Polarisator nach Anspruch 1, dadurch gekennzeichnet, daß die Versiegelung der Oberfläche mit $SiO_x$ durch Physical Vapor Deposition (PVD), durch Plasma-Chemical Vapor Deposition (Plasma-CVD) oder durch Sputtering, bevorzugt durch PVD, erzeugt wird.

3. Polarisator nach Anspruch 2, dadurch gekennzeichnet, daß die $SiO_x$-Schutzschicht eine Dicke von 10 nm bis 10 µm, bevorzugt von 100 nm bis 1 µm hat.

4. Polarisator nach Anspruch 1, dadurch gekennzeichnet, daß er zusätzlich beidseitig aufgebrachte transparente, biegsame Deckschichten aufweist, die auf die $SiO_x$-Schichten mit Hilfe von Silikat oder organischen Klebern, bevorzugt Silikat, geklebt sind.

5. Polarisator nach Anspruch 4, dadurch gekennzeichnet, daß er zwischen der $SiO_x$-versiegelten polarisierenden Schicht und/oder den Deckschichten und der Silikatschicht ein Silan oder Borat enthält.

6. Polarisator nach Anspruch 4, dadurch gekennzeichnet, daß die Silikatschicht ein Silan und/oder ein Borat enthält.

7. Polarisator nach Ansprüchen 5 und 6, dadurch gekennzeichnet, daß das Silan der Formel:

$$Si(R_1)_n(R_2)_{4-n}$$

entspricht, worin

$R_1$ unabhängig voneinander Halogen oder Alkoxy,
$R_2$ unabhängig voneinander Alkyl oder Alkenyl und
n eine Zahl 2, 3 oder 4 bedeuten.

8. Polarisator nach Anspruch 1, dadurch gekennzeichnet, daß das Polymer ein teilweise dehydratisierter Polyvinylalkohol oder ein Polyacetylen enthaltender Polyvinylalkohol, bevorzugt ein Polyacetylen enthaltender Polyvinylalkohol ist.

9. Polarisator nach Anspruch 1, dadurch gekennzeichnet, daß zusätzliche, dichroitische Substanzen enthalten sind.

10. Polarisator nach Anspruch 8, dadurch gekennzeichnet, daß das Polymer ein Polyacetylen enthaltender Polyvinylalkohol ist, dessen Polyvinylalkohol vor oder nach der Acetylenpolymerisation durch Tempern bei 150 bis 250°C durch Säurebehandlung oder durch Tempern und Säurebehandlung teilweise dehydratisiert wird und dadurch eine polarisierende Wirkung von < 450 nm bis 850 nm aufweist.

**Claims**

1. Thermostable, flexible polarizer having a polarizing layer of a polymer containing conjugated double bonds, characterized in that it has $SiO_x$-sealed surfaces, where x has any desired value from 1 to 2, preferably from 1.1 to 1.9, particularly preferably from 1.4 to 1.8.

2. Polarizer according to Claim 1, characterized in that the sealing of the surface with $SiO_x$ is produced by physical vapour deposition (PVD), by plasma chemical vapour deposition (plasma CVD) or by sputtering, preferably by PVD.

3. Polarizer according to Claim 2, characterized in that the $SiO_x$ protective layer has a thickness of from 10 nm to 10 $\mu$m, preferably from 100 nm to 1 $\mu$m.

4. Polarizer according to Claim 1, characterized in that it additionally has transparent, flexible outer layers applied to both sides which are bonded to the $SiO_x$ layers with the aid of silicate or organic adhesives, preferably silicate.

5. Polarizer according to Claim 4, characterized in that it contains a silane or borate between the $SiO_x$-sealed polarizing layer and/or the outer layers and the silicate layer.

6. Polarizer according to Claim 4, characterized in that the silicate layer contains a silane and/or a borate.

7. Polarizer according to Claims 5 and 6, characterized in that the silane conforms to the formula:

$$Si(R_1)_n(R_2)_{4-n}$$

in which

R_1, independently of one another, are halogen or alkoxy,
R_2, independently of one another, are alkyl or alkenyl, and
n is the number 2, 3 or 4.

8. Polarizer according to Claim 1, characterized in that the polymer is a partially dehydrated polyvinyl alcohol or a polyacetylene-containing polyvinyl alcohol, preferably a polyacetylene-containing polyvinyl alcohol.

9. Polarizer according to Claim 1, characterized in that it contains additional, dichroic substances.

10. Polarizer according to Claim 8, characterized in that the polymer is a polyacetylene-containing polyvinyl alcohol whose polyvinyl alcohol is partially dehydrated before or after the acetylene polymerization by conditioning at from 150 to 250°C, by acid treatment or by conditioning and acid treatment, and consequently has a polarizing action from < 450 nm to 850 nm.

**Revendications**

1. Polariseur thermostable, flexible avec une couche polarisante constituée d'un polymère présentant des doubles liaisons conjuguées, caractérisé en ce qu'il présente des surfaces métallisées avec $SiO_x$, où x prend des valeurs quelconques entre 1 et 2, de préférence entre 1,1 et 1,9, encore mieux entre 1,4 et 1,8.

2. Polariseur selon la revendication 1, caractérisé en ce que la métallisation de la surface avec $SiO_x$ est réalisée par dépôt en phase gazeuse par procédé chimique (PVD), par dépôt en phase gazeuse par procédé chimique dans un plasma (plasma - CVD) ou par pulvérisation cathodique, de préférence par PVD.

3. Polariseur selon la revendication 2, caractérisé en ce que la couche protectrice de $SiO_x$ présente une épaisseur de 10 nm à 10 $\mu$m, de préférence de 100 nm à 1 $\mu$m.

4. Polariseur selon la revendication 1, caractérisé en ce qu'il présente de plus des couches de couverture flexibles, transparentes, appliquées sur les deux côtés, lesquelles sont collées sur les couches de $SiO_x$ à l'aide d'un silicate ou de colles organiques, de préférence d'un silicate.

5. Polariseur selon la revendication 4, caractérisé en ce qu'il contient entre la couche polarisante métallisée avec $SiO_x$ et/ou les couches de couverture et la couche de silicate un silane ou un borate.

**6.** Polariseur selon la revendication 4, caractérisé en ce que la couche de silicate contient un silane et/ou un borate.

**7.** Polariseur selon les revendications 5 et 6, caractérisé en ce que le silane correspond à la formule :

$$Si(R_1)_n(R_2)_{4-n}$$

dans laquelle

$R_1$ représente indépendamment un atome d'halogène ou un groupe alcoxy,
$R_2$ représente indépendamment un groupe alkyle ou alcényle et
$n$ représente le nombre 2, 3 ou 4.

**8.** Polariseur selon la revendication 1, caractérisé en ce que le polymère est un poly(alcool vinylique) partiellement déshydraté ou un poly(alcool vinylique) contenant du polyacétylène, de préférence un poly(alcool vinylique) contenant du polyacétylène.

**9.** Polariseur selon la revendication 1, caractérisé en ce que sont contenues des substances supplémentaires dichroïques.

**10.** Polariseur selon la revendication 8, caractérisé en ce que le polymère est un poly(alcool vinylique) contenant du polyacétylène, dont le poly(alcool vinylique) est partiellement déshydraté avant ou après la polymérisation d'acétylène par maintien à température à de 150 à 250°C par traitement avec un acide ou par maintien à température et traitement avec un acide et présente par là une action polarisante de <450 nm jusqu'à 850 nm.